(19) Europäisches Patentamt

European Patent Office

Office européen des brevets

(11) EP 0 598 660 B1

## (12) FASCICULE DE BREVET EUROPEEN

(45) Date de publication et mention
de la délivrance du brevet:
**07.01.1998 Bulletin 1998/02**

(21) Numéro de dépôt: **93402782.2**

(22) Date de dépôt: **16.11.1993**

(51) Int. Cl.$^6$: **C03C 17/09**, C03C 17/06,
C23C 14/18

(54) **Vitrage à propriétés de transmission variant avec l'incidence**

Verglasung mit Transmissionseigenschaften die variieren mit dem Lichteinfall

Glazing with transmission properties varying with the incidence

(84) Etats contractants désignés:
**AT BE CH DE ES FR GB IT LI LU NL PT SE**

(30) Priorité: **17.11.1992 FR 9213769**

(43) Date de publication de la demande:
**25.05.1994 Bulletin 1994/21**

(73) Titulaire: **SAINT-GOBAIN VITRAGE
92400 Courbevoie (FR)**

(72) Inventeurs:
• **Macquart, Philippe
F-92600 Asnieres (FR)**
• **Bernard, Claude
F-77410 Anet s/Marne (FR)**

(74) Mandataire:
**Menes, Catherine et al
SAINT-GOBAIN RECHERCHE 39, Quai Lucien
Lefranc
93300 Aubervilliers (FR)**

(56) Documents cités:
**EP-A- 0 438 357          EP-A- 0 440 377
FR-A- 2 348 165**

• **JOURNAL OF APPLIED PHYSICS vol. 67, no. 2 ,
15 Janvier 1990 , NEW YORK US pages 1030 -
1036 YASUHITO GOTOH 'STRUCTURES AND
PROPERTIES OF CHROMIUM THIN FILMS
PREPARED BY ANISOTROPIC-EMMISION-
EFFECT SPUTTER DEPOSITION'**

## Description

L'invention concerne les vitrages, en particulier les vitrages recouverts de couches minces obtenues par les techniques de vide comme la pulvérisation cathodique et dont les propriétés optiques varient en fonction de l'incidence de la lumière.

Dans de nombreux cas, l'on souhaiterait disposer de vitrages dont les propriétés optiques et énergétiques varient en fonction de la direction d'illumination ou d'observation. Traditionnellement, un tel effet est obtenu par des jalousies ou des stores vénitiens mais ces systèmes ont leurs limites esthétiques ou pratiques. Ils sont en particulier mal adaptés à l'automobile.

Cependant, justement dans les automobiles modernes le besoin de tels systèmes se fait sentir de plus en plus. Les parties vitrées ont des surfaces de plus en plus grandes qui sont de plus en plus inclinées et offrent ainsi particulièrement en été, lorsque le soleil est haut, de très vastes sections disponibles pour l'ensoleillement ce qui entraîne une surchauffe de l'habitacle. Les procédés habituels pour diminuer la transmission en augmentant la réflexion ou l'absorption des vitrages atteignent hélas très vite leurs limites puisque les réglementations imposent des transmissions lumineuses minimales pour les vitrages d'une automobile quels qu'ils soient. Il parait donc particulièrement intéressant de pouvoir disposer d'un vitrage qui puisse assurer au conducteur d'une automobile la transmission lumineuse requise mais qui permette de diminuer la transmission - particulièrement la transmission énergétique - dans les autres directions.

Mais le besoin d'un vitrage à transmission variable ne se limite pas à l'automobile, dans le bâtiment également les domaines d'application sont multiples. Dans les habitations et les bureaux on désire se protéger contre l'ensoleillement mais garder le plus de contacts possible avec le monde extérieur. De même, il existe un besoin en vitrages fonctionnels qui favorisent l'éclairage naturel, en particulier dans les locaux professionnels spécialement dans les bureaux dits "paysagés" c'est-à-dire des bureaux collectifs de très grande profondeur. Il est alors souhaité d'accroître l'éclairement au fond des locaux mais de garder un niveau supportable au voisinage des fenêtres. Il s'agit donc de combattre la décroissance naturelle de l'éclairement lorsqu'on s'éloigne de la paroi vitrée. Dans le passé, des verres imprimés spéciaux avec une structure prismatique ont été développés pour remplir cette fonction mais outre qu'ils empêchent la vision claire de l'environnement extérieur, ils sont salissants car leur surface au relief très prononcé "accroche" la poussière. De plus, les techniques de laminage qui permettent de les fabriquer sont délicates lorsqu'il faut obtenir un effet optique précis.

L'invention se donne pour tâche de fournir un vitrage dont la transmission lumineuse et énergétique varie en fonction de l'angle d'incidence de la lumière et qui puisse être fabriqué industriellement c'est-à-dire en particulier dans des dimensions compatibles avec l'utilisation dans l'application comme vitrage automobile ou bâtiment avec une qualité satisfaisante, c'est-à-dire, en particulier une identité des performances entre différents points du vitrage.

Une technique holographique a été proposée pour fournir des vitrages automobiles qui possèdent pour le conducteur, la transmission lumineuse requise mais qui ont une forte réflexion pour le rayonnement solaire dans la mesure où il atteint le vitrage sous une incidence différente. En particulier, les demandes de brevet allemand DE 31 36 946 et DE 38 22 814 proposent des méthodes pour réaliser un film holographique à intégrer dans un vitrage automobile. Ces techniques, séduisantes sur le plan théorique et qui permettent la réalisation de prototypes performants ne sont pas encore suffisamment développées pour aboutir à des produits bon marché dont l'usage puisse se généraliser.

Au laboratoire, on connaît par ailleurs le moyen de créer sur des substrats transparents, en verre en général, des couches minces à structure "colonnaire" avec une direction des axes des colonnes différente de la normale à la surface. Ces structures réalisées sur de petites surfaces, le plus souvent de l'ordre du centimètre carré utilisaient des techniques de vide.

C'est ainsi que dans l'article "Angular selective window coatings : theory and experiment" par MBISE, SMITH, NIKLASSON et GRANQVIST, SPIE vol. 1149 Optical materials technology for energy efficiency and solar energy conversion VIII (1989) p. 179-199), on propose une méthode d'évaporation thermique d'argent et de chrome, la source d'évaporation (le métal placé dans un creuset) était ponctuelle et les différentes incidences obtenues toutes sur le même substrat placé à 30 cm de la source. Les échantillons obtenus possédaient aux endroits correspondant à une direction de dépôt oblique donnée (par exemple 80°) une transmission lumineuse variable selon la direction de la lumière incidente. Une telle technique d'évaporation thermique avec une ou plusieurs sources ponctuelles est inexploitable industriellement pour l'obtention de couches colonnaires car à chaque point de l'échantillon correspond une direction de dépôt différente et donc non seulement une transmission lumineuse normale différente mais également une loi de dépendance de l'angle d'incidence différente.

J.W. PATTEN in "The influences of Surface topography and angle of adatom incidence on growth structure in sputtered chromium", Thin Solid Films, 63 (1979) 121-129 décrit une technique de pulvérisation cathodique dans laquelle un diaphragme (diamètre 2,5 cm) est placé devant la cible. Le substrat possède des facettes orientées selon six angles différents de 0 à 90° ce qui permet l'obtention d'échantillons de couches d'une surface au maximum de 1cm$^2$. Les mesures effectuées sur les couches colonnaires ne sont pas de nature optique.

Ainsi les techniques de l'art antérieur, si elles permettaient d'étudier les phénomènes de base ne fournissaient aucune solution au problème de la production industrielle des couches colonnaires.

On connaît par ailleurs des moyens pour diaphragmer les cathodes de pulvérisation cathodique en plaçant devant les cibles des masques soit en tôle perforée, soit faits de treillis déployés ou de toiles métalliques mais leur fonction est l'obtention de couches d'épaisseurs variables, la variation du rapport entre les trous et les parties pleines des écrans permettant de varier l'épaisseur des couches obtenus dans des conditions définies.

D'autres techniques ont été proposées pour sélectionner parmi les particules émises par la cible qui équipe la cathode d'une installation de pulvérisation, celles qui sont émises sensiblement perpendiculairement à la surface de la cible. Ainsi, le brevet DD 285 897 propose de placer devant la cible une série de lames parallèles entre elles, perpendiculaires à sa surface (et à l'axe de la cathode). Le but est de maîtriser l'épaisseur des dépôts sur des objets de forme ronde.

L'invention concerne un vitrage fait d'un substrat transparent comportant une couche à base de métal avec les axes de croissance de la couche parallèles à des droites contenues dans un dièdre d'ouverture étroite dont l'ouverture $2 \Delta \alpha$ est inférieure à 15° et dont le plan bissecteur fait avec le substrat un angle $\alpha$ aigu inférieur à 40°.

Dans une variante de l'invention, la couche est faite d'un matériau absorbant et la transmission de rayonnement varie en fonction de la direction d'incidence.

Selon l'invention également, dans un procédé de dépôt de couches minces anisotropes par pulvérisation cathodique d'une cible sur un substrat, les particules émises par la cible sont canalisées par un guide et dirigées obliquement sur le plan du substrat, leurs directions d'impact sur le substrat sont parallèles à des droites contenues dans un dièdre d'ouverture étroite dont l'ouverture $2 \Delta \alpha$ est inférieure à 15 degrés et dont le plan bissecteur fait avec le plan du substrat un angle $\alpha$ inférieur à 40°.

De préférence, la cathode de pulvérisation est un magnétron planar dont l'axe est sensiblement parallèle au plan du substrat qui lui, se déplace dans son plan.

Lorsque le substrat est un vitrage bombé, il reste fixe par rapport à un plan dit plan du substrat.

La cible utilisée est avantageusement ou bien en alliage de nickel-chrome, en chrome ou bien en tantale et la pulvérisation s'effectue en atmosphère d'argon.

Dans une variante, après le dépôt de tantale, la pulvérisation se termine par l'adjonction d'oxygène à l'argon.

L'invention concerne également l'utilisation pour la mise en oeuvre du procédé selon l'invention d'un dispositif pour canaliser les particules émises par la cible de forme allongée d'une cathode de pulvérisation cathodique sur un substrat en déplacement par rapport à elle et utilisant des déflecteurs plans parallèles entre eux, liés à la cathode, les déflecteurs étant associés pour former un guide et étant parallèles à l'axe de la cathode.

Avantageusement, les déflecteurs font avec le plan du substrat un angle inférieur à 40 degrés et la géométrie de la cathode, en particulier la position des aimants dans le cas d'un magnétron planar, la géométrie et la position des déflecteurs et celle du substrat sont telles que les directions d'impact des particules restent parallèles à des droites contenues dans un dièdre d'ouverture $2 \Delta \alpha$ inférieure à 15 degrés.

La technique de l'invention permet ainsi d'obtenir industriellement des couches à sélectivité angulaire importante. Les moyens de production sont traditionnels et faciles à mettre en oeuvre. Les produits obtenus sont de même nature que des produits qui ont fait leurs preuves dans l'industrie, en particulier dans l'industrie automobile ils bénéficient simplement en plus de la propriété de sélectivité optique.

La **figure 1** montre une vue schématique de l'installation de dépôt,

La **figure 2** représente l'incidence des particules et celle des rayons lumineux d'évaluation de la couche sur l'échantillon.

La technique utilisée est la pulvérisation cathodique non-réactive ou réactive. De préférence, on utilise des cathodes à "magnétron" qui permettent d'accroître la vitesse de pulvérisation. Les matériaux utilisables pour constituer les couches minces à sélection angulaire sont d'une manière générale tous les matériaux absorbants, en particulier les métaux.

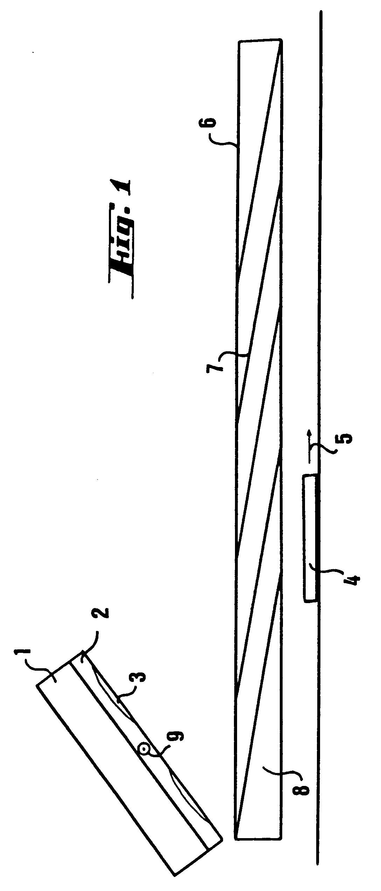

La **figure 1** représente une coupe horizontale de l'installation d'essai. Il s'agit d'une installation de pulvérisation cathodique classique utilisant un magnétron du type de celui décrit dans le brevet DE 24 63 431 C2. Ce magnétron 1 est situé verticalement dans une enceinte à vide non représentée sur la figure, c'est-à-dire que l'axe de symétrie 9 longitudinal de la cible "race track" est vertical. On peut introduire des gaz tels que l'argon ou des gaz réactifs. La cathode magnétron 1 est équipée d'une cible 2, il s'agit de préférence d'une cible métallique. Sur la figure, on voit en 3 les zones d'érosion maximum de la cible 2, là où la pulvérisation est effectuée essentiellement et entre ces zones, l'axe 9. L'installation est équipée d'un support d'échantillon non représenté qui permet un déplacement horizontal de l'échantillon vertical 4 dans son plan dans la direction de la flèche 5.

Parallèlement à l'échantillon 4 entre celui-ci et la cathode 1, on a placé un guide 6. Celui-ci est constitué d'un ensemble de plaques planes verticales 7 parallèles entre elles, ces plaques 7 sont assemblées grâce à un bâti 8 qui permet de fixer l'ensemble. Les plaques 7 sont distantes de 10 mm. Le matériau du guide 6 est avantageusement de l'acier inoxydable. L'ensemble est fixe par rapport à la cathode 1 et sensiblement parallèle à l'échantillon plan 4 à environ 10 mm de lui.

Le dispositif d'essai permettait aux particules émises par la cible de frapper l'échantillon selon des trajectoires situées dans des plans qui faisaient avec la surface de l'échantillon un angle a compris entre 5 et 20°.

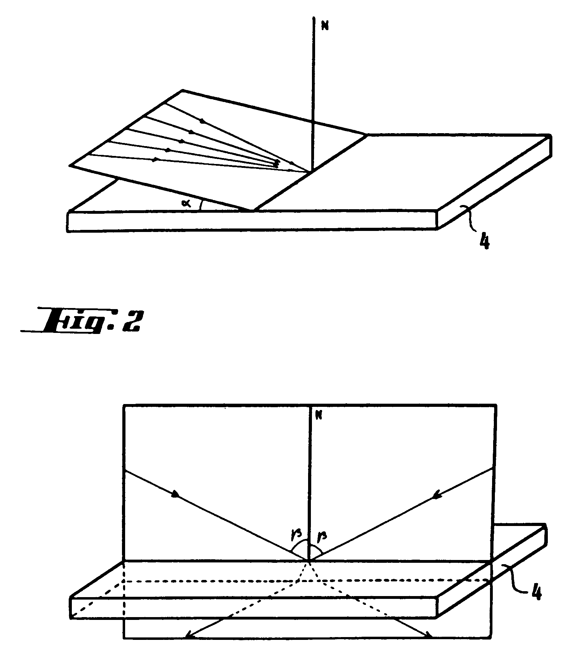

La **figure 2** montre d'une part comment les particules arrivent en un point M sous des incidences rasantes, dans des plans qui faisaient avec la surface de l'échantillon lors des essais des angles $\alpha$ tels que :

$$5° < \alpha < 20°$$

et d'autre part, cette même **figure 2** montre dans sa partie basse comment l'évaluation de la couche se fait en ce même point M en comparant la transmission sous une incidence de $+\beta$ ou de $-\beta$ par rapport à la normale MN.

Les mesures de transmission lumineuses sont faites longueur d'onde par longueur d'onde puis elles sont intégrées pour obtenir la transmission lumineuse $T_L$ (illuminant C) et éventuellement la transmission énergétique solaire $T_E$.

EXEMPLE 1

La cible du magnétron est faite d'un alliage nickel-chrome (47-53) elle a des dimensions de 200 x 100 mm$^2$. La pression dans l'enceinte était de 0,3 Pa et le gaz étant un mélange argon-oxygène avec des débits respectifs de 100 et 2 cm$^3$/mn (conditions normales de température et de pression, CNTP). La tension établie entre la cathode et l'enceinte était de 450 volts et le courant s'établissait à 1 ampère. La durée totale de la pulvérisation, qui se faisait en plusieurs passages en va-et-vient de l'échantillon 4 en verre flotté clair d'une épaisseur de 4 mm sous le guide 8, était de 1100 secondes.

La couche, grise d'aspect; a été mesurée optiquement sous l'incidence $\beta$ de + 60° et - 60°, on a obtenu les valeurs de $T_L$ suivantes :

$$T_L = 19,1 \% \text{ et } T_L = 21,3 \%$$

soit une différence relative de plus de 10 %.

EXEMPLE 2

Cette fois, la cible est la même que dans l'exemple 1, mais le gaz est de l'argon pur (débit 100 cm$^3$/mn) la pression dans l'enceinte est montée à 0,5 Pa. La tension imposée est de 500 volts et l'intensité du courant s'établit à 0,5 A. Au bout de 1010 secondes, on a obtenu une couche plus sombre que la couche précédente dont les caractéristiques sous ± 60° étaient :

$$T_L = 16,3 \% \text{ et } T_L = 18,4 \%$$

soit une différence relative de 11 %.

EXEMPLE 3

Toujours avec la même cible NiCr, on a effectué un nouveau dépôt toujours sur un verre clair de 4 mm. Les conditions étaient les suivantes :

gaz : Ar (97 %) + $O_2$ (3 %)
pression : 2 hPa
tension : 556 V
courant : 1 A
durée de la pulvérisation : 4800 secondes

Pour voir la compatibilité de la couche avec une application automobile, l'échantillon obtenu a été feuilleté par l'intermédiaire d'un film intercalaire en polyvinylbutyral d'épaisseur 0,76 mm avec un verre de 3 mm d'épaisseur. L'évaluation optique était faite ici sous un angle de 0° et de ± 50°. On a obtenu :

| incidence | $T_L$ (%) | $T_E$ (%) |
|-----------|-----------|-----------|
| 0° | 35,4 | 35,0 |
| +50° | 28,0 | 29,0 |
| -50° | 38,0 | 36,0 |

Un tel vitrage installé dans la lunette arrière d'un véhicule automobile permettrait, si la lunette avait une inclinaison sur l'horizontale de 40°, d'obtenir pour un soleil haut sur l'horizon, une transmission énergétique de seulement 29 % tandis que le conducteur aurait vers l'arrière une vision qui s'élèverait à 38 % (valeurs à comparer à la transmission normale de 35 %).

Dans cet exemple, la différence relative en $T_L$ est très élevée, elle atteint 26 %.

EXEMPLE 4

Ici la cible est en chrome pur. On a avec cette cible effectué deux types de dépôt sur un verre clair de 4 mm. D'une part une couche de chrome seul et d'autre part, la même couche recouverte de son oxyde.

Les conditions expérimentales sont les mêmes que pour l'exemple 1, simplement, dans le premier cas l'atmosphère est d'argon pur et, dans le second - pour la couche d'oxyde - elle comporte en plus, 23 % d'oxygène. Par ailleurs dans ce second cas toujours, il n'existe pas de guide ni de déflecteurs entre la cible et l'échantillon.

Les résultats optiques des deux systèmes étaient pratiquement identiques :

| Incidence | $T_L$ |
|-----------|-------|
| 0° | 0,31 |
| +60° | 0,33 |
| -60° | 0,25 |

ce qui correspond à une différence relative de 24 %.

Des tests comparatifs d'abrasion et de résistance chimique ont été réalisés sur les deux types d'échantillons.

Les essais d'abrasion sont effectués à l'aide de meules faites de poudre abrasive noyée dans un élastomère. La machine est fabriquée par la Société Taber Instrument Corporation aux Etats-Unis. Il s'agit du modèle 174, "Standard Abrasion Tester" les meules sont des CS10F chargées de 500 grammes.

Les tests ont montré que, pour atteindre une augmentation de transmission - donc un état d'abrasion - donnée, il fallait deux fois plus de rotations dans le cas du chrome recouvert de son oxyde que dans le cas du métal seul.

Pour le test d'attaque chimique les résultats vont dans le même sens, ce test consiste à plonger l'échantillon pendant un temps plus ou moins long dans un bain d'acide HCl.1M à 96°C. Après huit heures, seule la couche de Cr colonnaire montre des délaminations macroscopiques de quelques mm$^2$ réparties de façon uniforme à la surface. Le métal protégé par une couche d'oxyde, même très mince ne montre aucune évolution après une immersion de la même durée.

On voit ainsi qu'en recouvrant une couche de métal colonnaire, assez fragile, par une couche d'oxyde, on améliore très sensiblement sa tenue aussi bien mécanique que chimique.

EXEMPLE 5

On a, dans l'exemple 5, essayé d'appliquer la technique de couche décrite dans la demande de brevet européen EP 0 438 357, il s'agit d'une couche absorbante particulièrement dure et qui peut s'utiliser seule, sans protection en dépôt sur un vitrage monolithique trempé.

La cible est en tantale. Les conditions expérimentales sont les suivantes :

gaz : 100 % Ar (100 %)
pression : 2,5.10$^{-5}$hPa
tension : 445 V
courant : 1 A
durée de pulvérisation : 4800 secondes

Une telle durée, sur l'installation de la figure 1, nécessite vingt passages de l'échantillon 4 derrière le guide 8.

A la fin de l'opération de dépôt de la couche métallique, on a effectué deux passages dans des conditions qui ne différaient que par la nature du gaz. C'est-à-dire qu'à l'argon, on a ajouté de l'oxygène dans une proportion de 23 %. Des essais préliminaires ont montré que ce dépôt supplémentaire d'une couche oxydée ne modifiait pratiquement pas les caractéristiques optiques de la couche. En revanche, la résistance à l'abrasion est sensiblement améliorée.

La transmission lumineuse de l'échantillon précédent a été mesurée sous + et - 60° d'angle d'incidence. On trouve les deux valeurs $T_L$ = 30,9 et $T_L$ = 42,0 % ce qui fournit une différence relative de 26 %.

Ainsi, les exemples précédents montrent que la technique de l'invention permet d'obtenir des couches absorbantes possédant une bonne sélectivité optique en fonction de la direction d'observation.

Par rapport aux techniques de l'art antérieur, connues et expérimentées au laboratoire, et dans lesquelles une source de surface faible envoyait des particules sur un échantillon, lui aussi de surface réduite, c'est-à-dire dans lesquels les directions d'impact étaient limitées par un cône étroit, la technique de l'invention telle qu'elle est mise en oeuvre dans les exemples précédents a montré, de manière surprenante qu'il suffit que les directions d'impact soient comprises à l'intérieur d'un dièdre étroit tout en ayant, à l'intérieur de celui-ci toutes les orientations, pour que la sélectivité soit maintenue.

Ce phénomène surprenant, puisque les "colonnes" de la couche "colonnaire" ne possèdent pas ici un axe comme à l'habitude mais une infinité d'axes de croissance contenus dans un dièdre d'ouverture faible, permet d'utiliser la pulvérisation cathodique - technique industrielle éprouvée - avec des rendements élevés et des vitesses de dépôt importantes, ce qui n'aurait pas pu se faire si l'on avait dû sélectionner une seule direction d'impact parmi toutes les directions de l'espace. La méthode est simple, facile à réaliser dans l'industrie, à partir de conditions de dépôt de couches absorbantes connues. Les investissements supplémentaires sont peu chers. Quant aux couches, malgré une tenue mécanique moins bonne que celle des couches isotropes de même nature, elle peuvent facilement être améliorées par le dépôt d'une couche protectrice. La technique de dépôt est valable quelles que soient les dimensions des plaques sur lesquelles il se fait, elle est donc bien adaptée tant pour les vitrages plans de grande dimension (vitrages bâtiment) qu'aux vitrages bombés de l'automobile.

Dans ce dernier cas on préfère déposer sur le vitrage déjà bombé. Celui-ci se déplace devant le guide 8 de la figure 1, le "plan" d'incidence des particules garde la même direction indépendamment de l'orientation réelle du plan tangent au vitrage à l'endroit de l'impact (il s'agit en réalité d'un dièdre d'angle compris entre $\alpha - \Delta\alpha$ et $\alpha + \Delta\alpha$ puisque comme on l'a vu, les particules ne sont pas toutes dans un même plan mais situées à l'intérieur d'un dièdre d'ouverture 2 Δ α. Dans les exemples il s'agit du dièdre compris entre 5 et 15° c'est-à-dire qu'α est égal à 12,5° et Δα à 7,5°). En effet, le plan d'incidence des particules fait l'angle α (figure 2) avec le plan qu'on appelle "le plan du substrat". (Celui-ci est en réalité défini de la manière suivante : il est contenu dans le vitrage et parallèle à la fois à l'axe de la cible de pulvérisation et à la direction de déplacement de l'échantillon). On retrouve ainsi sur le vitrage bombé des directions définies pour les effets optiques. Mais, comme on le souhaite, les effets optiques recherchés se retrouvent sur le vitrage monté, avec des directions privilégiées par rapport à la voiture (et non par rapport au plan tangent au vitrage en chaque endroit comme ce serait le cas si le dépôt était effectué sur un vitrage plan qu'on bomberait ultérieurement).

En conclusion, le procédé permet d'obtenir une sélectivité définie (par exemple, un maximum de transmission dans une direction parallèle à l'axe de la voiture) même sur des vitrages bombés. Dans le cas de techniques concurrentes comme l'holographie, une telle performance ne serait possible que si l'hologramme de chaque vitrage était créé individuellement sur le vitrage bombé lui-même, ce qui entraînerait un coût de production très élevé. En revanche, le dépôt de couches minces par pulvérisation cathodique sur des vitrages automobiles bombés est, elle, d'ores et déjà une technique industrielle éprouvée.

## Revendications

1. Vitrage fait d'un substrat transparent comportant une couche à base de métal, les axes de croissance de la couche étant parallèles à des droites contenues dans un dièdre dont l'ouverture forme un angle aigu vu du substrat, **caractérisé en ce que** l'ouverture du dièdre 2Δα est inférieure à 15° **et en ce que** le plan bissecteur du dièdre fait avec le substrat un angle α aigu inférieur à 40°.

2. Vitrage selon la revendication 1, **caractérisé en ce que** la couche est faite d'un matériau absorbant **et en ce que** la transmission de rayonnement varie en fonction de la direction d'incidence.

3. Procédé de dépôt de couches minces anisotropes sur un substrat par pulvérisation cathodique d'une cible, les particules émises par la cible sont canalisées par un guide (6) de telle sorte que leurs directions d'impact soient parallèles à des droites contenues dans un dièdre dont l'ouverture forme un angle aigu vu du substrat, **caractérisé en ce que** l'ouverture du dièdre 2Δα est inférieure à 15 degrés **et en ce que** le plan bissecteur du dièdre fait avec le plan du substrat un angle α inférieur à 40°.

4. Procédé selon la revendication 3, **caractérisé en ce que** la cathode (1) de pulvérisation est un magnétron planar dont l'axe (9) est sensiblement parallèle au plan du substrat (4) **et en ce que** celui-ci se déplace dans son plan.

5. Procédé selon la revendication 4, **caractérisé en ce que** le substrat est un vitrage bombé qui reste fixe par rapport à un plan dit plan du substrat.

6. Procédé selon l'une des revendications 3 à 5, **caractérisé en ce que** la cible utilisée (2) est en alliage de nickel-chrome **et en ce que** la pulvérisation s'effectue en atmosphère composée essentiellement d'argon.

7. Procédé selon l'une des revendications 3 à 6, **caractérisé en ce que** la cible utilisée (2) est en tantale ou en chrome **et en ce que** la pulvérisation s'effectue en atmosphère d'argon.

8. Procédé selon la revendication 7, **caractérisé en ce que** la pulvérisation se termine par l'adjonction d'oxygène à l'argon.

9. Utilisation pour la mise en oeuvre du procédé selon la revendication 3 d'un dispositif utilisant une cathode de pulvérisation cathodique de forme allongée en déplacement par rapport à un substrat et utilisant des déflecteurs plans parallèles entre eux, liés à la cathode, **caractérisé en ce que** les déflecteurs (7) sont associés pour former un guide (6) **et en ce qu'**ils sont parallèles à l'axe (9) de la cathode (1).

10. Utilisation d'un dispositif selon la revendication 9, **caractérisé en ce que** les déflecteurs font avec le plan du substrat un angle inférieur à 40 degrés.

11. Utilisation d'un dispositif selon la revendication 9 ou 10, **caractérisé en ce que** la géométrie de la cathode (1), en particulier la position des aimants dans le cas d'un magnétron planar, la géométrie et la position des déflecteurs (7) et celle du substrat (4) sont telles que les directions d'impact des particules restent parallèles à des droites contenues dans un dièdre d'ouverture 2Δα inférieure à 15 degrés.

## Claims

1. Glazing pane made of a transparent substrate, comprising a film based upon metal, the growth axes of the film being parallel to straight lines contained within a dihedron, the opening of which makes an acute angle seen from the substrate, characterized in that the opening of the dihedron 2Δα is less than 15° and in that the bisector plane of the dihedron makes an acute angle α of less than 40° with the substrate.

2. Glazing pane according to claim 1, characterized in that the film is made of an absorbent material and in that the transmission of radiation varies as a function of the direction of incidence.

3. Process for the deposition of thin anisotropic films onto a substrate by cathodic sputtering of a target, the particles emitted by the target are channelled by a guide (6) in such a way that their impact directions are parallel to straight lines contained within a dihedron, the opening of which makes an acute angle seen from the substrate, characterized in that the opening of the dihedron 2Δα is less than 15° and in that the bisector plane of the dihedron makes an angle α less than 40° with the plane of the substrate.

4. Process according to claim 3, characterized in that the sputtering cathode (1) is a planar magnetron, the axis (9) of which is substantially parallel to the plane of the substrate (4) and in that the latter displaces in its plane.

5. Process according to claim 4, characterized in that the substrate is a curved pane, which remains fixed with respect to a plane known as plane of the substrate.

6. Process according to one of claims 3 to 5, characterized in that the target used (2) is of nickel-chrome alloy and in that the sputtering is carried out in an atmosphere composed essentially of argon.

7. Process according to one of claims 3 to 6, characterized in that the target used (2) is of tantalum or of chromium and in that the sputtering is carried out in an argon atmosphere.

8. Process according to claim 7, characterized in that the sputtering terminates with the addition of oxygen to the argon.

9. Use, for the carrying out of the process according to claim 3, of a device employing a cathodic sputtering cathode of elongate form in movement with respect to a substrate and using plane deflectors parallel to one another, linked to the cathode, characterized in that the deflectors (7) are associated together to form a guide (6) and in that they are parallel to the axis (9) of the cathode (1).

10. Use of a device according to claim 9, characterized in that the deflectors make an angle of less than 40° with the plane of the substrate.

11. Use of a device according to claim 9 or 10, characterized in that the geometry of the cathode (1), in particular the position of the magnets in the case of a planar magnetron, the geometry and the position of the deflectors (7) and that of the substrate (4), are such that the impact directions of the particles remain parallel to straight lines contained within a dihedron of opening 2Δα of less than 15 degrees.

**Patentansprüche**

1. Verglasung, hergestellt aus einem transparenten Substrat, das eine Schicht auf der Basis eines Metalls umfaßt, wobei die Aufwachsachsen der Schicht Parallel zu Geraden verlaufen, die in einem Dieder enthalten sind, dessen Öffnung mit dem Substrat einen spitzen Winkel bildet, **dadurch gekennzeichnet, daß** die Öffnung 2Δα des Dieders kleiner als 15° ist **und daß** die winkelhalbierende Ebene des Dieders mit dem Substrat einen spitzen Winkel α von kleiner als 40° bildet.

2. Verglasung nach Anspruch 1, **dadurch gekennzeichnet, daß** die Schicht aus einem absorbierenden Material hergestellt ist **und daß** die Strahlungsdurchlässigkeit in Abhängigkeit vom Einfallswinkel variiert.

3. Verfahren zum Abscheiden anisotroper dünner Schichten auf einem Substrat durch Kathodenzerstäubung eines Targets, wobei die vom Target emittierten Teilchen von einer Leiteinrichtung (6) derart ausgerichtet werden, daß ihre Auftreffrichtungen parallel zu Geraden verlaufen, die in einem Dieder enthalten sind, dessen Öffnung mit dem Substrat einen spitzen Winkel bildet, **dadurch gekennzeichnet, daß** die Öffnung 2Δα des Dieders kleiner als 15 Grad ist und daß die winkelhalbierende Ebene des Dieders mit der Substratebene einen Winkel α von kleiner als 40° bildet.

4. Verfahren nach Anspruch 3, **dadurch gekennzeichnet, daß** die zu zerstäubende Kathode (1) ein Planarmagnetron ist, dessen Achse (9) zur Ebene des Substrats (4) im wesentlichen parallel ist **und daß** dieses sich in seiner Ebene fortbewegt.

5. Verfahren nach Anspruch 4, **dadurch gekennzeichnet, daß** das Substrat eine gebogene Verglasung ist, die in bezug auf eine als Substratebene bezeichnete Ebene unbeweglich bleibt.

6. Verfahren nach einem der Ansprüche 3 bis 5, **dadurch gekennzeichnet, daß** das verwendete Target (2) aus einer Chromnickellegierung hergestellt ist **und daß** die Zerstäubung in einer Atmosphäre stattfindet, die im wesentlichen aus Argon besteht.

7. Verfahren nach einem der Ansprüche 3 bis 6, **dadurch gekennzeichnet, daß** das verwendete Target (2) aus Tantal oder Chrom besteht **und daß** die Zerstäubung in einer Argonatmosphäre stattfindet.

8. Verfahren nach Anspruch 7, **dadurch gekennzeichnet, daß** die Zerstäubung durch Zugabe von Sauerstoff zum Argon beendet wird.

9. Verwendung einer Vorrichtung zur Durchführung des Verfahrens nach Anspruch 3, in welcher für die Kathodenzerstäubung eine längliche Kathode eingesetzt wird, die sich in bezug auf ein Substrat bewegt, und mit der Kathode in Verbindung stehende, zueinander parallele flache Leitplatten eingesetzt werden, **dadurch gekennzeichnet, daß** die Leitplatten (7) miteinander verbunden sind, um eine Leiteinrichtung (6) zu bilden, **und daß** sie zur Achse (9) der Kathode (1) parallel stehen.

10. Verwendung einer Vorrichtung nach Anspruch 9, **dadurch gekennzeichnet, daß** die Leitplatten mit der Substratebene einen Winkel von kleiner als 40 Grad bilden.

11. Verwendung einer Vorrichtung nach Anspruch 9 oder 10, **dadurch gekennzeichnet, daß** die Geometrie der Kathode (1), insbesondere im Fall eines Planarmagnetrons die Lage der Magnete, die Geometrie und die Lage der Leitplatten (7) und die des Substrats (4) derart sind, daß die Auftreffrichtungen der Teilchen parallel zu Geraden bleiben, die in einem Dieder mit einer Öffnung $2\Delta\alpha$ von kleiner als 15 Grad enthalten sind.

Fig. 1

# Fig. 2